(19) **Europäisches Patentamt / European Patent Office / Office européen des brevets**

(11) **EP 4 206 705 B1**

(12) **FASCICULE DE BREVET EUROPEEN**

(45) Date de publication et mention
de la délivrance du brevet:
**08.05.2024 Bulletin 2024/19**

(21) Numéro de dépôt: **22216655.5**

(22) Date de dépôt: **23.12.2022**

(51) Classification Internationale des Brevets (IPC):
***G01R 31/36*** (2020.01)

(52) Classification Coopérative des Brevets (CPC):
**G01R 31/36**

(54) **DÉTERMINATION DU RENDEMENT D'UN ACCUMULATEUR ÉLECTRIQUE PAR CONVERSION**

BESTIMMUNG DER EFFIZIENZ EINES ELEKTRISCHEN AKKUMULATORS DURCH UMWANDLUNG

DETERMINING THE EFFICIENCY OF AN ELECTRIC STORAGE BATTERY BY CONVERSION

(84) Etats contractants désignés:
AL AT BE BG CH CY CZ DE DK EE ES FI FR GB GR HR HU IE IS IT LI LT LU LV MC ME MK MT NL NO PL PT RO RS SE SI SK SM TR

(30) Priorité: **28.12.2021 FR 2114598**

(43) Date de publication de la demande:
**05.07.2023 Bulletin 2023/27**

(73) Titulaire: **COMMISSARIAT À L'ÉNERGIE ATOMIQUE ET AUX ÉNERGIES ALTERNATIVES**
**75015 Paris (FR)**

(72) Inventeurs:
• **KAROUI HENCHIRI, Fathia**
 **38054 GRENOBLE cedex 09 (FR)**
• **KLEIN, Jean-Marie**
 **38054 GRENOBLE cedex 09 (FR)**
• **MONTARU, Maxime**
 **38054 GRENOBLE cedex 09 (FR)**

(74) Mandataire: **INNOV-GROUP**
**310, avenue Berthelot**
**69372 Lyon Cedex 08 (FR)**

(56) Documents cités:
**US-B2- 9 166 257**

• **BOBANAC VEDRAN ET AL: "Determining Lithium-ion Battery One-way Energy Efficiencies: Influence of C-rate and Coulombic Losses", IEEE EUROCON 2021 - 19TH INTERNATIONAL CONFERENCE ON SMART TECHNOLOGIES, IEEE, 6 juillet 2021 (2021-07-06), pages 385-389, XP033973130, DOI: 10.1109/EUROCON52738.2021.9535542**
• **LALL PRADEEP ET AL: "Effect of Charging Cycle Elevated Temperature Storage and Thermal Cycling on Thin Flexible Batteries in Wearable Applications", 2019 IEEE 69TH ELECTRONIC COMPONENTS AND TECHNOLOGY CONFERENCE (ECTC), IEEE, 28 mai 2019 (2019-05-28), pages 370-381, XP033603740, DOI: 10.1109/ECTC.2019.00064**

## Description

DOMAINE TECHNIQUE

L'invention concerne le domaine des accumulateurs électriques, tels que les accumulateurs électrochimiques, et vise plus particulièrement les techniques permettant de déterminer un indicateur représentatif du rendement d'un accumulateur électrique.

ART ANTÉRIEUR

Pour la gestion d'un accumulateur électrique en général, et la gestion de ses cycles de charge et de décharge, il peut être avantageux, voire nécessaire, de disposer d'un indicateur représentatif du rendement de l'accumulateur électrique. Un indicateur couramment employé est un paramètre dénommé « rendement » (« Round Trip Efficiency », en anglais) qui est le rapport, à un instant donné de la vie de l'accumulateur, entre ce qui est restitué par l'accumulateur lors d'une phase de décharge et ce qui est apporté à l'accumulateur lors d'une phase de charge,.

Les accumulateurs électriques sont généralement associés à un système de gestion de batterie (BMS pour « Battery Management System », en anglais) permettant le contrôle des cycles de charge et de décharge ainsi que de multiples opérations visant à allonger la durée de vie de l'accumulateur. Les systèmes de gestion de batterie actuels nécessitent un plus grand nombre de paramètres en entrée, avec des précisions plus fines, afin de procéder à des opérations avancées de gestion de batterie.

Les techniques connues de détermination du rendement d'une cellule de batterie passent généralement par une mesure du rendement de chaque cellule de l'accumulateur électrique. Pour cela, chaque cellule est complètement déchargée puis complètement rechargée, ou complètement rechargée puis complètement déchargée. Lors de la recharge complète ou de décharge complète, la quantité de charges accumulée dans la cellule ou extraite de la cellule peut être mesurée par comptage coulométrique. Un inconvénient de ces techniques de détermination du rendement est qu'elles nécessitent la mise en oeuvre d'une décharge complète de la cellule suivie d'une recharge complète, ou d'une recharge complète suivie d'une décharge complète, ce qui est relativement contraignant. Ces techniques ne sont ainsi pas applicables aux accumulateurs qui ne sont jamais complètement déchargés ni complètement chargés, et dont seuls des cycles de charge et de décharge partielle sont disponibles.

Ces techniques sont aussi difficilement applicables au cas d'accumulateurs plus complexes, comportant de nombreuses cellules raccordées selon différents sous-ensembles, et pour lesquels les mesure à l'échelle de la cellule ne sont pas disponibles. Bobanac et al., "Determining Lithium-ion Battery One-way Energy Efficiencies: Influence of C-rate and Coulombic Losses", IEEE EUROCON 2021, 19th International Conférence on Smart Technologies, July 6-8, pages 385-389, XP033973130, divulgue un procédé de détermination d'un indicateur de rendement d'un accumulateur électrique.

EXPOSÉ DE L'INVENTION

L'invention a pour but d'améliorer les procédés de l'art antérieur, dans la détermination d'un indicateur de rendement d'un accumulateur électrique.

À cet effet, l'invention vise un procédé de détermination d'un indicateur de rendement d'un accumulateur électrique, ce procédé comportant les étapes suivantes :

- acquérir des mesures de paramètres représentatifs au moins du courant relatif à l'accumulateur électrique, et d'un indicateur d'état de charge de l'accumulateur électrique, cette acquisition étant réalisée sur une période de mesure comportant un ensemble d'opérations de charge et de décharge de l'accumulateur électrique ; et

- a) convertir l'ensemble d'opérations de charge et de décharge de la période de mesure en un ensemble équivalent de cycles reconstitués symétriques, chaque cycle reconstitué symétrique comportant une opération de charge et une opération de décharge de même amplitude de l'indicateur d'état de charge (une même amplitude de charge ou de décharge) ;

- b) sélectionner au moins un cycle reconstitué symétrique dont l'amplitude de l'indicateur d'état de charge est supérieure à une valeur prédéterminée ;

- c) pour une grandeur physique prédéterminée impliquant au moins le courant relatif à l'accumulateur électrique, et pour au moins un cycle reconstitué symétrique sélectionné : déterminer une première quantité de ladite grandeur physique prédéterminée qui est fournie à l'accumulateur électrique lors de l'opération de charge, et déterminer une deuxième quantité de ladite grandeur physique prédéterminée qui est fournie par l'accumulateur électrique lors de l'opération de décharge ;

- d) déterminer l'intégrale par rapport au temps de ladite première quantité et de ladite deuxième quantité ;

- e) déterminer un indicateur de rendement de l'accumulateur électrique en divisant l'intégrale de la deuxième quantité par l'intégrale de la première quantité.

Selon un autre objet, l'invention vise un système de gestion de batterie ou un système de gestion de l'énergie d'une centrale électrique, configuré pour mettre en oeuvre le procédé décrit.

Selon un autre objet, l'invention vise un produit programme d'ordinateur comprenant des instructions qui conduisent le système de gestion de batterie ou le système de gestion de l'énergie d'une centrale électrique à exécuter les étapes du procédé décrit.

Le procédé selon l'invention détermine le rendement de l'accumulateur directement à partir des données disponibles et notamment des données disponibles dans un système de gestion de batteries classiques, quel que soit l'échelle à laquelle ces données sont produites. En effet, un accumulateur électrique peut être constitué d'une ou plusieurs cellules élémentaires, éventuellement reliées entre elles selon différents niveaux de complexité, de façon à obtenir un générateur électrique de tension et de capacité désirée. Notamment, un accumulateur électrique peut être :

- une simple cellule élémentaire ;
- un module fait d'un ensemble de ces cellules unitaires reliées ;
- un rack constitué d'un ensemble de modules;
- un conteneur constitué d'un ensemble de racks déconnectables ;
- un ensemble de conteneurs formant une centrale de stockage.

Quelle que soit l'échelle considérée pour un tel accumulateur électrique, le procédé selon l'invention détermine le rendement de l'accumulateur à son échelle, sans nécessiter de mesures au niveau des éventuels sous-ensembles composant l'accumulateur. Le procédé selon l'invention s'applique à tout accumulateur associé à des moyens électroniques permettant de réaliser les mesures de tension, de courant et/ou d'état de charge nécessaires. Les systèmes de gestion de batterie classiques sont généralement capables de fournir ces données.

Le procédé selon l'invention ne requiert pas d'opération spécifique telle qu'une recharge complète ou une décharge complète. Aucune intrusion n'est nécessaire dans le fonctionnement de la batterie, la détermination du rendement étant réalisée avec les données classiquement disponibles, de manière totalement transparente sur les cycles de charge et de décharge.

Une gestion fine de la charge de l'accumulateur, en charge ou en décharge, est permise par l'invention. Il est par exemple possible de déterminer avec une meilleure précision les moments où charge et décharge sont préférentiellement stoppées, au vu du rendement estimé de l'accumulateur à cet instant. Il est aussi possible de déterminer quelle est la charge à appliquer à l'accumulateur pour disposer d'une quantité d'énergie en sortie déterminée. Une telle gestion affinée de la charge et décharge de l'accumulateur contribue de manière significative à l'augmentation de la durée de vie des accumulateurs.

Le procédé selon l'invention peut comporter les caractéristiques additionnelles suivantes, seules ou en combinaison :

- dans l'étape a), la conversion en cycles reconstitués symétriques est réalisée en associant par paires les minima croissants et les maxima décroissants des opérations de charge et de décharge de la période de mesure ;

- dans l'étape a), la conversion est réalisée par application de la méthode de comptage rainflow ;

- ladite grandeur physique prédéterminée est le courant relatif à l'accumulateur électrique, l'intégrale de cette grandeur par rapport au temps étant une capacité, l'indicateur de rendement déterminé étant un indicateur de rendement faradique ;

- ladite grandeur physique prédéterminée est la puissance relative à l'accumulateur électrique, l'intégrale de cette grandeur par rapport au temps étant une énergie, l'indicateur de rendement déterminé étant un indicateur de rendement énergétique ;

- lors de l'étape b), une pluralité de cycles reconstitués symétriques sont sélectionnés, et à l'étape e), les indicateurs de rendement relatifs à tous les cycles reconstitués symétriques sélectionnés sont moyennés ;

- à l'étape b), tous les cycles reconstitués symétriques dont l'amplitude de l'indicateur d'état de charge est supérieure à ladite valeur prédéterminée, de l'ensemble de la période de mesure, sont sélectionnés ;

- après l'étape d), l'intégrale par rapport au temps de ladite première quantité et de ladite deuxième quantité est rapportée à l'amplitude de l'indicateur d'état de charge, en divisant l'intégrale par l'amplitude de l'indicateur d'état de charge du cycle reconstitué symétrique sélectionné ;

- après l'étape d), l'intégrale par rapport au temps de ladite première quantité et de ladite deuxième quantité est rapportée à un nombre de sous-ensembles déconnectables qui constituent l'accumulateur électrique, en multipliant l'intégrale par un facteur relatif au rapport entre les sous-ensembles connectés lors de l'opération de décharge du cycle reconstitué symétrique sélectionné, et les sous-ensembles connectés lors de l'opération de charge du cycle reconstitué symétrique sélectionné ;

- à l'étape b), ladite valeur prédéterminée est égale à 10 % ;

- lesdites mesures de paramètres représentatifs au moins du courant délivré par l'accumulateur électrique, et de l'indicateur d'état de charge de l'accumulateur électrique, sont réalisées par un système de gestion de batterie connecté à l'accumulateur électrique ;

- ledit indicateur de l'état de charge de l'accumulateur électrique est : l'état de charge quand cette donnée est disponible et fiable ; la tension limitante dans le cas contraire.

## PRÉSENTATION DES FIGURES

D'autres caractéristiques et avantages de l'invention ressortiront de la description non limitative qui suit, en référence aux dessins annexés dans lesquels :

- la figure 1 illustre un exemple simplifié d'ensembles de cycles de charge et de décharge d'un accumulateur ;

- la figure 2 illustre un exemple de sélection de cycles en utilisant la tension limitante ;

- la figure 3 illustre un ensemble équivalent de cycles reconstitués symétriques de l'ensemble de cycles de la figure 1 ;

- la figure 4 illustre un premier exemple réel d'ensembles de cycles de charge et de décharge d'un accumulateur ;

- la figure 5 illustre un deuxième exemple réel d'ensembles de cycles de charge et de décharge d'un accumulateur.

## DESCRIPTION DÉTAILLÉE

Le procédé selon l'invention vise à déterminer un indicateur de rendement d'un accumulateur. L'accumulateur peut-être tout accumulateur doté d'un système de gestion de batterie permettant de fournir la tension, le courant, et l'état de charge de l'accumulateur. L'état de charge (SOC pour « State of Charge », en anglais) est un indicateur donnant le rapport entre la charge actuelle de l'accumulateur et sa capacité totale actuelle. Ces données sont bien connues dans le domaine de la gestion des batteries et sont de préférence directement délivrées par le système de gestion de batterie. Le procédé selon l'invention lui-même peut être mis en en oeuvre par le système de gestion de batterie.

L'indicateur de rendement obtenu par la mise en oeuvre du procédé peut être un indicateur de rendement énergétique et/ou un indicateur de rendement faradique. Le rendement énergétique est, sur un cycle donné de charge/décharge, le rapport de l'énergie (par exemple en Wh) fournie par l'accumulateur lors de sa phase de décharge, sur l'énergie (par exemple en Wh) qui a été fournie à l'accumulateur lors de sa phase de charge. Le rendement faradique est, sur un cycle donné de charge/décharge, le rapport de la quantité de charge (par exemple en Ah) tirée de l'accumulateur lors de sa phase de décharge, sur la quantité de charge (par exemple en Ah) qui a été fournie à l'accumulateur lors de sa phase de charge.

L'accumulateur électrique peut être tout accumulateur, quelle que soit son échelle, associé à un système de gestion de batterie, notamment une cellule élémentaire, un module, un rack, un conteneur, une centrale de stockage.

Dans le présent exemple, l'accumulateur électrique est un conteneur formé de plusieurs racks déconnectables. Dans cette mise en oeuvre particulière du procédé, ce dernier nécessite également un indicateur relatif au nombre de racks présents à chaque instant dans le conteneur formant l'accumulateur Cette information peut également être fournie par le système de gestion de batterie.

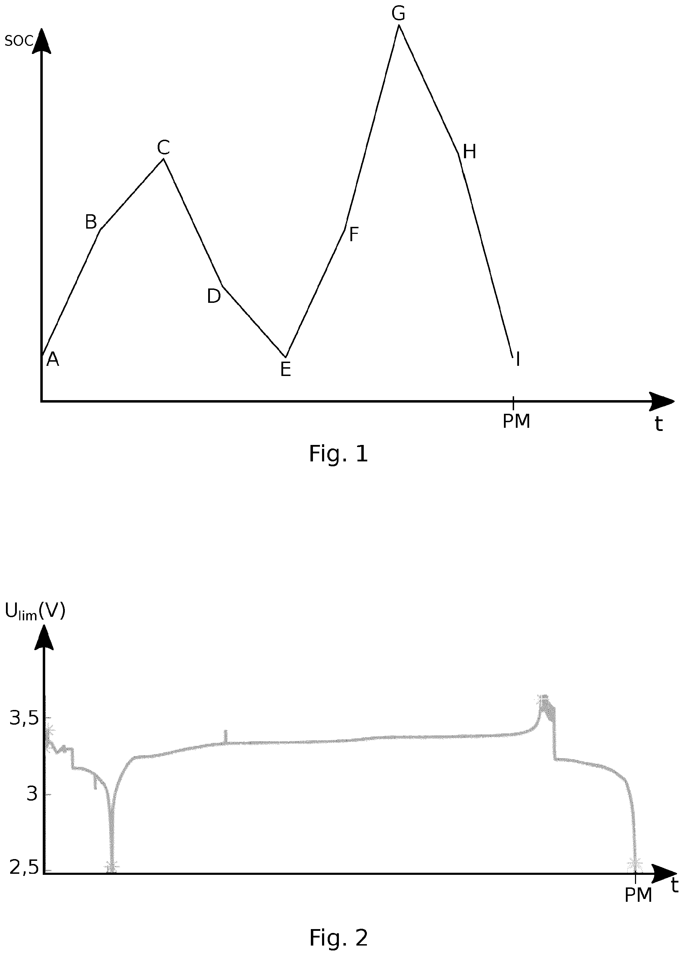

Le procédé de détermination du rendement de l'accumulateur prend place dans une fenêtre temporelle d'acquisition dénommée « période de mesure ». La figure 1 illustre un exemple simple d'évolution d'un indicateur représentatif de l'état de charge de l'accumulateur électrique en fonction du temps t, sur la période de mesure PM. Dans le présent exemple, l'indicateur représentatif de l'état de charge est l'état de charge SOC. La période de mesure PM comporte un ensemble d'opérations de charge et de décharge de l'accumulateur, toutes les données évoquées de tension, courant, et état de charge de l'accumulateur, ayant été relevées durant cette période de mesure PM. La période de mesure PM peut être statique ou bien glissante, c'est-à-dire qu'elle s'actualise au fur et à mesure.

Une étape préalable est de choisir la grandeur utilisée pour le découpage à l'étape suivante des données en cycles utilisables pour le calcul du rendement. Il s'agit de vérifier la présence d'un état de charge calculé par le système de gestion de batterie et de calculer la différence entre cet état de charge et un état de charge coulométrique (calculé par intégration des Ah). Si l'état de charge n'existe pas ou si cette différence est supérieure à une valeur de tolérance prédéfinie (par exemple 3 %), nous utilisons pour la sélection des cycles une tension appelée « tension limitante » $U_{lim}$, sinon nous utilisons l'état de charge.

La reconstitution de la tension $U_{lim}$ se fait de la manière suivante :

- si l'échelle de la batterie est la cellule, la tension $U_{lim}$ est directement la tension cellule ;
- si l'échelle de la batterie est un assemblage de plusieurs cellules, la tension $U_{lim}$ est reconstituée à partir des tensions minimales et maximales des cellules selon la phase de fonctionnement de la batterie (repos, charge, décharge) comme suit : si le courant est proche de zéro, indiquant une phase de repos, $U_{lim}$ est la moyenne entre la tension minimale et la tension maximale des cellules de la batterie ; si le courant indique une phase de charge, $U_{lim}$ est égale à la tension maximale des cellules de la batterie ; si le courant indique une phase de décharge, $U_{lim}$ est égale à la tension minimale des cellules de la batterie.

La figure 2 illustre un exemple de sélection de cycles avec la tension $U_{lim}$.

Une première étape du procédé consiste à convertir l'ensemble d'opérations de charge et de décharge qui ont lieu sur l'accumulateur durant la période de mesure PM en un ensemble équivalent de cycles reconstitués symétriques. Un cycle symétrique est un cycle comportant une opération de charge et une opération de décharge qui ont la même amplitude en ce qui concerne l'état de charge ou l'évolution de la tension. Par exemple, un cycle symétrique comporte une première opération de charge qui va porter l'état de charge de l'accumulateur de 20 % jusqu'à 80 %, puis une opération de décharge au cours de laquelle l'état de charge reviens de la valeur 80 % à la valeur 20 %.

Les cycles symétriques résultants de cette conversion sont dits « reconstitués » car ils sont issus d'une réorganisation, avec d'éventuelles approximations, de cycles réels de la figure 1.

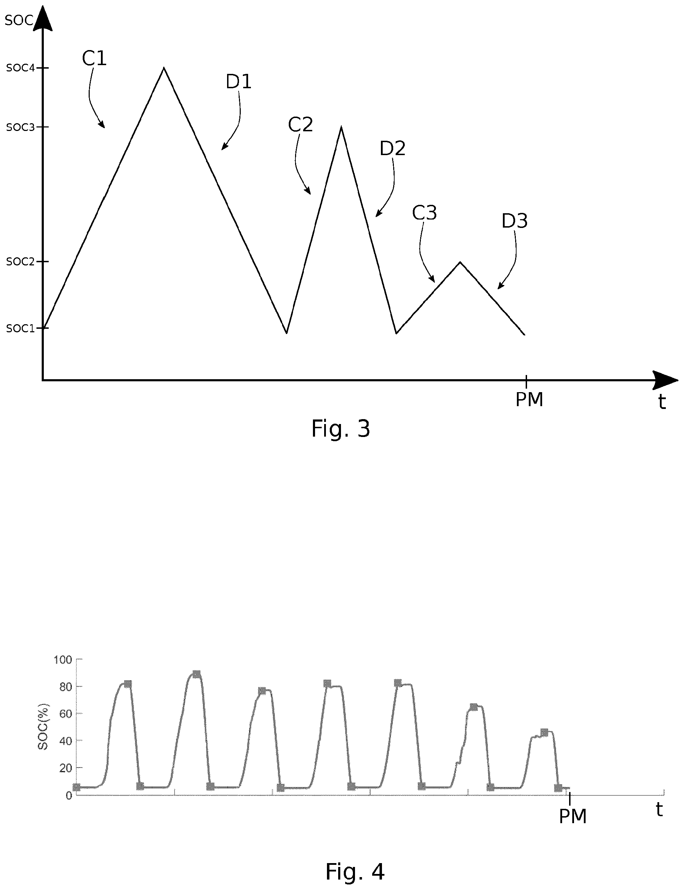

La figure 3 illustre les principes sur lesquels se base une telle conversion. La figure 1 étant relative à un exemple théorique de vie de l'accumulateur très simplifié pour des fins didactiques, la figure 3 illustre un exemple de l'ensemble équivalent de cycles reconstitués symétriques. Le cas ici est décrit sur base du SOC, mais une approche similaire peut être mis en oeuvre sur base de l'évolution de la tension limitante $U_{lim}$.

Dans cet exemple illustratif, l'accumulateur subit successivement (voir figure 1) :

- une opération de charge conduisant à une augmentation de l'état de charge selon une première pente (segment AB) puis selon une seconde pente (segment BC) ;
- une opération de décharge conduisant à une diminution de l'état de charge suivant une première pente (segment CD) puis selon une deuxième pente (segment DE) ;
- une deuxième opération de charge conduisant à une augmentation de l'état de charge selon une première pente (segment EF) puis selon une seconde pente (segment FG) ;
- une deuxième opération de décharge conduisant à une diminution de l'état de charge suivant une première pente (segment GH) puis selon une seconde pente (segment HI).

L'ensemble de cycles de charge et décharge réels de la figure 1 est, selon cet exemple trivial, converti dans l'ensemble équivalent de cycles reconstitués symétriques de la figure 3, de la manière suivante :

- les segments AB et EF sont mis bout à bout pour former l'opération de charge C1 d'un premier cycle reconstitué symétrique ;
- les segments CD et GH sont mis bout à bout pour former l'opération de décharge D1 du premier cycle reconstitué symétrique ;
- le segment FG constitue l'opération de charge C2 d'un deuxième cycle reconstitué symétrique et le segment HI constitue l'opération de décharge D2 de ce deuxième cycle reconstitué symétrique ;
- le segment BC constitue l'opération de charge C3 d'un troisième cycle reconstitué symétrique et le segment DE constitue l'opération de décharge D3 de ce troisième cycle reconstitué symétrique.

Le premier cycle reconstitué symétrique porte l'état de charge de l'accumulateur d'une valeur minimale SOC1 à une valeur maximale SOC4, puis une opération de décharge ramène l'état de charge de cette valeur maximale SOC4 jusqu'à la valeur initiale SOC1. Le deuxième cycle reconstitué symétrique porte l'état de charge de la valeur SOC1 jusqu'à une valeur maximale SOC3, puis ramène l'état de charge à la valeur initiale SOC1. Le troisième cycle reconstitué symétrique porte l'état de charge de la valeur SOC1 jusqu'à une valeur maximale SOC2, puis ramène l'état de charge à la valeur initiale SOC1.

Pour certaines applications, dont les cycles de charge/décharge sont simples et réguliers, un algorithme relativement simple se chargera de cette conversion comme illustré aux figures 1 et 3. Cependant de nombreuses applications sont relatives à des cycles de charge de décharge complexes et irréguliers. Dans ce cas, des algorithmes plus sophistiqués seront employés pour l'opération de conversion décrite. Dans le présent exemple, une réalisation préférée concerne l'utilisation de la méthode de comptage rainflow, développée à l'origine dans le domaine des matériaux pour des estimations de fatigue cyclique, et qui est aujourd'hui utilisée dans de nombreuses applications où un comportement cyclique peut être observé, notamment dans l'éolien, les machines tournantes, et la charge des batteries.

La méthode de comptage rainflow consiste à associer par paire les minima croissants et les maxima décroissants de la courbe initiale, et peut être mise en oeuvre par de nombreux algorithmes connus.

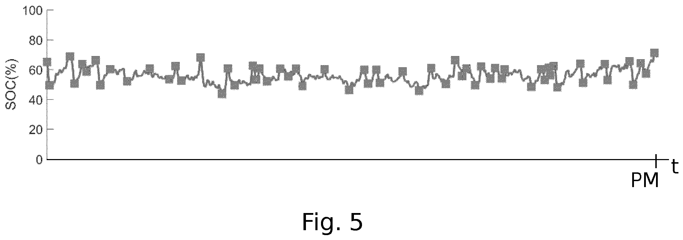

Les figures 4 et 5 illustrent deux exemples réels d'une période de mesure PM comportant un ensemble d'opérations de charge et de décharge pour un accumulateur électrique. La figure 4 illustre un premier profil de charge/décharge d'amplitude assez importante et relativement régulière dans l'ensemble, malgré quelques irrégularités locales. La figure 5 illustre un autre profil de charge/décharge, présentant une amplitude de charge et de décharge plus faible et dont les opérations de charge et de décharge sont très irrégulières.

Pour ces deux profils illustratifs, la mise en oeuvre d'un algorithme implémentant la méthode de comptage de cycle rainflow permettra, dans chaque cas, une conversion efficace en un ensemble équivalent de cycles reconstitués symétriques, Sur les figures 4 et 5, les carrés pleins représentent les points d'inflexion qui sont pris en compte pour la création des segments qui formeront les cycles reconstitués symétriques. Cette opération est réalisée en associant par paire les minima croissants et les maxima décroissants selon la méthode de comptage rainflow.

À cet effet, il est préférable de pouvoir paramétrer un seuil d'amplitude au-delà duquel une opération de décharge sera prise en compte dans la conversion. Par exemple, un seuil de 1 % entrainera que toute opération de décharge ayant une profondeur de décharge inférieure à 1 %, ne sera pas prise en compte dans l'opération de conversion.

À l'issue de cette étape de conversion, le système de gestion de batterie dispose donc d'un ensemble équivalent de cycles reconstitués symétriques, relatifs à la période de mesure.

Le procédé comporte ensuite une étape de filtrage dans laquelle seuls certains cycles reconstitués symétriques seront sélectionnés. Le système de gestion de batterie est paramétré avec une valeur prédéterminée d'amplitude d'état de charge au-delà de laquelle un cycle reconstitué symétrique sera sélectionné. Dans le présent exemple de sélection de cycles avec l'état de charge SOC, cette valeur prédéterminée est supérieure à 5 %, et préférentiellement de 10 %. Autrement dit, seuls les cycles reconstitués symétriques dont l'amplitude de charge et de décharge sera supérieure à 10 % seront sélectionnés pour la suite des opérations, les autres cycles étant ignorés. Notons que le procédé selon l'invention permet la prise en compte d'opérations de décharge même de faible amplitude (proches de 10 %), ce qui augmente le spectre des mesures sur lesquelles peut se baser l'estimation du rendement de l'accumulateur et qui donc augmente la précision de cette estimation. Dans le cas où la sélection de cycles se fait avec la tension limitante $U_{lim}$, la valeur prédéterminée correspondante sera supérieure à 0,5 et préférentiellement de 1.

Dans cette étape de filtrage, au moins un cycle symétrique reconstitué est sélectionné.

Le paramétrage du seuil (ici de 1 %) et de la valeur prédéterminée (ici de 10 %) rend le procédé applicable à de nombreux profils de charge et décharge et ne nécessite pas d'avoir accès à une phase particulière telle qu'une tension constante, une phase de repos, etc. Le procédé peut être ainsi appliqué à tous profils mêmes les plus irréguliers et les plus hachés, sans intrusion sur le fonctionnement des cycles de charge et de décharge.

Le procédé comporte ensuite une étape de calcul dans laquelle, pour le cycle reconstitué symétrique qui a été sélectionné (ou pour chaque cycle reconstitué symétrique, s'ils ont été plusieurs à être sélectionnés), une grandeur physique prédéterminée va être quantifiée. Cette grandeur physique prédéterminée peut être :

- le courant, si l'indicateur de rendement recherché est un indicateur de rendement faradique ;

- la puissance, si l'indicateur de rendement recherché est un indicateur de rendement énergétique.

Dans un premier exemple de réalisation, seul un cycle reconstitué symétrique a été sélectionné. Dans ce cas, le procédé, à cette étape, vise à déterminer une première quantité de cette grandeur physique (courant ou puissance) qui est fournie à l'accumulateur lors de l'opération de charge du cycle reconstitué symétrique en question, et à déterminer également une deuxième quantité de cette grandeur physique (courant ou puissance) qui est fournie par l'accumulateur lors de l'opération de décharge de ce cycle.

Dans le cas du rendement faradique, cette première quantité est le courant qui est fourni à l'accumulateur durant l'opération de charge, et cette deuxième quantité est le courant fourni par l'accumulateur durant l'opération de décharge.

Dans le cas du rendement énergétique, cette première quantité est la puissance qui est fournie à l'accumulateur durant l'opération de charge, et cette deuxième quantité est la puissance fournie par l'accumulateur durant l'opération de décharge. La puissance est calculée simplement en multipliant le courant et la tension de l'accumulateur (fournies par les acquisitions de mesure du système de gestion de batterie).

Le système de gestion de batterie procède ensuite à l'intégration de cette première quantité et de cette deuxième quantité. L'intégrale de la première quantité et l'intégrale de la deuxième quantité, par rapport au temps, sont ainsi calculées. Dans le cas du rendement faradique, ce calcul mène à une valeur de capacité (en Ah) pour l'opération de charge, et à une autre valeur de capacité (en Ah) pour l'opération de décharge. Dans le cas du rendement énergétique, le calcul mène à une valeur d'énergie (en Wh) pour l'opération de charge, et à une autre valeur d'énergie (en Wh) pour l'opération de décharge.

Notons que, comme il est question de cycles reconstitués, les opérations de charge et de décharge concernées ne forment pas nécessairement un cycle dans l'historique des charges et décharges réelles qu'a subi l'accumulateur. Ce cycle reconstitué assemble une opération de charge et une opération de décharge par le calcul, opérations qui peuvent être indépendantes en réalité.

L'indicateur de rendement est ensuite calculé en divisant l'intégrale de la deuxième quantité par l'intégrale de la première quantité.

Le rendement faradique est donc calculé en divisant la capacité de décharge par la capacité de charge, et éventuellement en multipliant par 100 pour obtenir un rapport exprimé sous forme de pourcentage.

Le rendement énergétique est quant à lui calculé en divisant l'énergie de décharge par l'énergie de charge, et éventuellement en multipliant par 100 pour obtenir un rapport exprimé sous forme de pourcentage.

Cet indicateur de rendement (qu'il soit faradique ou énergétique) est ainsi obtenu à un instant de la vie de l'accumulateur correspondant à la période de mesure PM (on considère que le cycle reconstitué symétrique unique qui a été sélectionné est représentatif du rendement sur la période PM), selon la formule suivante, pour un cycle reconstitué symétrique sélectionné idx :

$$Eff = \frac{DGh_{idx}}{CGh_{idx}}$$

dans laquelle :

- *Eff* est l'indicateur de rendement (faradique ou énergétique) ;
- $DGh_{idx}$ est l'intégrale de la quantité de grandeur physique prédéterminée (capacité ou énergie) relative à la phase de décharge du cycle reconstitué symétrique sélectionné idx ;
- $CGh_{idx}$ est l'intégrale de la quantité de grandeur physique prédéterminée (capacité ou énergie) relative à la phase de charge du cycle reconstitué symétrique sélectionné idx.

Selon un deuxième exemple de réalisation, plusieurs cycles reconstitués symétriques sont sélectionnés à l'étape de filtrage. Ainsi, plusieurs cycles reconstitués symétriques, voire tous les cycles reconstitués symétriques de la période PM, dont l'amplitude en termes d'état de charge est supérieure à ladite valeur prédéterminée (ici 10 %), sont sélectionnés.

Selon ce deuxième exemple, pour chaque cycle reconstitué symétrique sélectionné, la première quantité de grandeur physique (courant ou puissance) et la deuxième quantité de cette grandeur physique (courant ou puissance) sont déterminées, puis sont intégrées par rapport au temps, pour enfin aboutir à l'indicateur de rendement (faradique ou énergétique) qui est relatif au cycle reconstitué symétrique considéré, et ce de la même manière que pour le premier exemple de réalisation décrit précédemment.

Cette opération permet d'obtenir une pluralité d'indicateurs de rendement (autant d'indicateurs de rendement que de cycles reconstitués symétriques sélectionnés). Ces différents indicateurs de rendement (faradiques ou énergétiques) sont ensuite moyennés. L'indicateur de rendement final, relatif à la période de mesure PM, pourra ainsi être obtenu par une simple moyenne arithmétique de la pluralité d'indicateurs de rendement. En variante, d'autres types de moyenne, éventuellement associées à des opérations de filtrage peuvent être mises en oeuvre, par exemple une moyenne olympique glissante sur un certain nombre de valeurs (par exemple 30 valeurs). La moyenne olympique d'une série de donnée est la moyenne des éléments de cette série dont on a supprimé la plus petite et la plus grande donnée, ou dont on a supprimé un pourcentage d'observation aux extrémités inférieures et supérieures de la distribution, de sorte à exclure les observations extrêmes. Pour cet exemple de moyenne glissante, la période de mesure PM est également glissante, actualisée au fur et à mesure du temps.

Un indicateur de rendement (qu'il soit faradique ou énergétique) est ainsi obtenu à un instant de la vie de l'accumulateur correspondant à la période de mesure PM.

En variante, dans le cas d'impossibilité de reconstituer un cycle symétrique par la méthode précédente, notamment pour certaines périodes de mesures de courte durée, le rendement relatif à un cycle détecté peut être déterminé en le ramenant à des valeurs relatives à l'accumulateur pleinement chargé (plutôt qu'à l'opération de charge, forcément partielle, du cycle considéré) et à l'accumulateur pleinement déchargé (plutôt qu'à l'opération de décharge, forcément partielle, du cycle considéré). Ce faisant, on génère par le calcul un équivalent virtuel de cycle symétrique, alors qu'il n'est pas présent dans la réalité de la période de mesure. Cette variante est applicable seulement dans le cas où la sélection de cycle est faite sur la base de l'état de charge SOC, et non sur la base de la tension limitante $U_{lim}$. Dans le cas de cette variante, l'intégrale de la quantité de grandeur physique prédéterminée (c'est-à-dire une valeur de capacité ou d'énergie, dans le présent exemple) relative à un cycle est divisée par l'amplitude en termes d'état de charge (c'est-à-dire la profondeur de charge ou de décharge) du cycle considéré. Pour un cycle détecté noté idx, la quantité de la grandeur physique prédéterminée (courant ou puissance) correspond à une différence d'état de charge notée : $SOC_{idis}$ - $SOC_{fdis}$, avec $SOC_{idis}$ qui est l'état de charge initial du cycle et $SOC_{fdis}$ qui est l'état de charge final du cycle idx.

En divisant l'intégrale de la quantité de grandeur physique prédéterminée déchargée lors de l'opération de décharge du cycle sélectionné (paramètre $DGh_{idx}$ dans la formule ci-après) par l'amplitude de charge considérée ($SOC_{idis}$ - $SOC_{fdis}$), on obtient le taux de la grandeur physique intégrée (capacité ou énergie) fournie par l'accumulateur lors de la phase de décharge, par unité d'amplitude d'état de charge.

En divisant l'intégrale de la quantité de grandeur physique prédéterminée fournie à l'accumulateur lors de l'opération de charge du cycle sélectionné (paramètre $CGh_{idx}$ dans la formule ci-après) par l'amplitude de charge considérée ( $SOC_{fcha}$ - $SOC_{icha}$), on obtient le taux de la grandeur physique intégrée (capacité ou énergie) fournie à l'accumulateur lors de la phase de charge, par unité d'amplitude d'état de charge. Considérer le taux de la grandeur physique intégrée (capacité ou énergie) par unité d'amplitude d'état de charge, lors d'une opération de charge et d'une opération de décharge, constitue une autre forme reconstituée de cycle reconstitué symétrique au sens de l'invention.

Selon cette variante, pour chacun des cycles sélectionnés idx, les formules de calcul, selon cette variante, sont les suivantes :

$$Idch = \frac{DGh_{idx}}{SOC_{idis} - SOC_{fdis}}$$

$$Icha = \frac{CGh_{idx}}{SOC_{fcha} - SOC_{icha}}$$

$$Eff = \frac{Idch}{Icha}$$

dans lesquelles :

- *Eff* est l'indicateur de rendement (faradique ou énergétique) ;
- *Idch* est l'intégrale de la quantité de grandeur physique prédéterminée (capacité ou énergie) relative à la phase de décharge du cycle sélectionné idx, par unité d'amplitude d'état de charge ;
- *Icha* est l'intégrale de la quantité de grandeur physique prédéterminée (capacité ou énergie) relative à la phase de charge du cycle sélectionné idx, par unité d'amplitude d'état de charge ;
- $DGh_{idx}$ est l'intégrale de la quantité de grandeur physique prédéterminée (capacité ou énergie) relative à la phase de décharge du cycle sélectionné idx ;
- $CGh_{idx}$ est l'intégrale de la quantité de grandeur physique prédéterminée (capacité ou énergie) relative à la phase de charge du cycle sélectionné idx ;
- $SOC_{idis}$ est l'état de charge initial lors de l'opération de décharge du cycle sélectionné idx ;
- $SOC_{fdis}$ est l'état de charge final lors de l'opération de décharge du cycle sélectionné idx ;
- $SOC_{icha}$ est l'état de charge initial lors de l'opération de charge du cycle sélectionné idx ;
- $SOC_{fcha}$ est l'état de charge final lors de l'opération de charge du cycle sélectionné idx.

Par ailleurs, le procédé étant, dans le présent exemple, appliqué à un conteneur formé d'un ensemble de racks qui sont déconnectables, le procédé peut optionnellement permettre d'éviter les variations brusques de l'indicateur de rendement final, qui seraient dues à une modification du nombre de racks connectés au sein du conteneur. Le but est de ne pas imputer une simple déconnexion de rack au sein du conteneur, à un phénomène de vieillissement. Dans ce cas, quel que soit le mode de calcul du rendement relatif à un cycle reconstitué symétrique ou cycle détecté en variante, le calcul du rendement est de préférence basé sur la capacité ou l'énergie à l'échelle des racks, plutôt qu'à l'échelle du conteneur. L'intégrale de la quantité de grandeur physique prédéterminée (capacité ou énergie) relative à la phase de décharge ou de la phase de charge du cycle reconstitué symétrique sélectionné ou cycle détecté en variante est, dans ce cas, divisée par un facteur relatif au nombre de sous-ensembles déconnectables (ici les racks) qui constituent l'accumulateur électrique (ici le conteneur).

Ainsi, pour chaque cycle reconstitué symétrique sélectionné ou cycle détecté en variante, l'intégrale de la quantité de grandeur physique prédéterminée (capacité ou énergie), qu'elle soit ramenée ou non à des valeurs relatives à l'accumulateur pleinement chargé et à l'accumulateur pleinement déchargé, est rapportée au nombre de racks disponibles.

Dans le cas général, la formule est la suivante :

$$Eff = \frac{DGh_{idx}}{CGh_{idx}} \times \frac{RC_{idx}}{RD_{idx}}$$

dans laquelle :

- *Eff* est l'indicateur de rendement (faradique ou énergétique) ;
- $DGh_{idx}$ est l'intégrale de la quantité de grandeur physique prédéterminée (capacité ou énergie) relative à la phase de décharge du cycle reconstitué symétrique sélectionné idx ;
- $CGh_{idx}$ est l'intégrale de la quantité de grandeur physique prédéterminée (capacité ou énergie) relative à la phase de charge du cycle reconstitué symétrique sélectionné idx ;
- $RC_{idx}$ est le nombre de racks connectés lors de la phase de charge du conteneur, pour le cycle idx ;
- $RD_{idx}$ est le nombre de racks connectés lors de la phase de décharge du conteneur, pour le cycle idx.

Dans le cas où l'intégrale de la quantité de grandeur physique prédéterminée (capacité ou énergie) est ramenée à des valeurs relatives à l'accumulateur pleinement chargé et à l'accumulateur pleinement déchargé, les formules sont les suivantes :

$$Idch = \frac{DGh_{idx}}{\left(SOC_{idis} - SOC_{fdis}\right) \times RD_{idx}}$$

$$Icha = \frac{CGh_{idx}}{\left(SOC_{fcha} - SOC_{icha}\right) \times RC_{idx}}$$

$$Eff = \frac{Idch}{Icha}$$

dans lesquelles :

- *Eff* est l'indicateur de rendement (faradique ou énergétique) ;
- *Idch* est l'intégrale de la quantité de grandeur physique prédéterminée (capacité ou énergie) relative à la phase de décharge du cycle sélectionné idx, par unité d'amplitude d'état de charge, rapportée au nombre de racks ;

- *Icha* est l'intégrale de la quantité de grandeur physique prédéterminée (capacité ou énergie) relative à la phase de charge du cycle sélectionné idx, par unité d'amplitude d'état de charge, rapportée au nombre de racks ;
- *DGh$_{idx}$* est l'intégrale de la quantité de grandeur physique prédéterminée (capacité ou énergie) relative à la phase de décharge du cycle sélectionné idx ;
- *CGh$_{idx}$* est l'intégrale de la quantité de grandeur physique prédéterminée (capacité ou énergie) relative à la phase de charge du cycle sélectionné idx ;
- *SOC$_{idis}$* est l'état de charge initial lors de l'opération de décharge du cycle sélectionné idx ;
- *SOC$_{fdis}$* est l'état de charge final lors de l'opération de décharge du cycle sélectionné idx ;
- *SOC$_{icha}$* est l'état de charge initial lors de l'opération de charge du cycle sélectionné idx ;
- *SOC$_{fcha}$* est l'état de charge final lors de l'opération de charge du cycle sélectionné idx.
- *RC$_{idx}$* est le nombre de racks connectés lors de la phase de charge de l'accumulateur, pour le cycle idx ;
- *RD$_{idx}$* est le nombre de racks connectés lors de la phase de décharge de l'accumulateur, pour le cycle idx.

De manière générale, l'indicateur de rendement est obtenu de manière actualisée à chaque nouvelle période de mesure (ou de glissement de la période PM) sans intrusion dans le fonctionnement des cycles de charge et de décharge.

## Revendications

1. Procédé de détermination d'un indicateur de rendement d'un accumulateur électrique, ce procédé comportant les étapes suivantes :

   - acquérir des mesures de paramètres représentatifs au moins du courant relatif à l'accumulateur électrique, et d'un indicateur d'état de charge de l'accumulateur électrique, cette acquisition étant réalisée sur une période de mesure (PM) comportant un ensemble d'opérations de charge et de décharge de l'accumulateur électrique ;

   ce procédé étant **caractérisé en ce qu'**il comporte les étapes suivantes :

   - a) convertir l'ensemble d'opérations de charge et de décharge de la période de mesure (PM) en un ensemble équivalent de cycles reconstitués symétriques, chaque cycle reconstitué symétrique comportant une opération de charge et une opération de décharge de même amplitude de l'indicateur d'état de charge ;
   - b) sélectionner au moins un cycle reconstitué symétrique dont l'amplitude de l'indicateur d'état de charge est supérieure à une valeur prédéterminée ;
   - c) pour une grandeur physique prédéterminée impliquant au moins le courant relatif à l'accumulateur électrique, et pour au moins un cycle reconstitué symétrique sélectionné : déterminer une première quantité de ladite grandeur physique prédéterminée qui est fournie à l'accumulateur électrique lors de l'opération de charge, et déterminer une deuxième quantité de ladite grandeur physique prédéterminée qui est fournie par l'accumulateur électrique lors de l'opération de décharge ;
   - d) déterminer l'intégrale par rapport au temps de ladite première quantité et de ladite deuxième quantité ;
   - e) déterminer un indicateur de rendement de l'accumulateur électrique en divisant l'intégrale de la deuxième quantité par l'intégrale de la première quantité.

2. Procédé selon la revendication 1, **caractérisé en ce que**, dans l'étape a), la conversion en cycles reconstitués symétriques est réalisée en associant par paires les minima croissants et les maxima décroissants des opérations de charge et de décharge de la période de mesure.

3. Procédé selon la revendication 2, **caractérisé en ce que**, dans l'étape a), la conversion est réalisée par application de la méthode de comptage rainflow.

4. Procédé selon l'une des revendications précédentes, **caractérisé en ce que** ladite grandeur physique prédéterminée est le courant relatif à l' accumulateur électrique, l'intégrale de cette grandeur par rapport au temps étant une capacité, l'indicateur de rendement déterminé étant un indicateur de rendement faradique.

5. Procédé selon l'une des revendications 1 à 3, **caractérisé en ce que** ladite grandeur physique prédéterminée est la puissance relative à l'accumulateur électrique, l'intégrale de cette grandeur par rapport au temps étant une énergie, l'indicateur de rendement déterminé étant un indicateur de rendement énergétique.

6. Procédé selon l'une des revendications précédentes, **caractérisé en ce que**, lors de l'étape b), une pluralité de cycles reconstitués symétriques sont sélectionnés, et à l'étape e), les indicateurs de rendement relatifs à tous les cycles reconstitués symétriques sélectionnés sont moyennés.

**7.** Procédé selon la revendication 6, **caractérisé en ce que**, à l'étape b), tous les cycles reconstitués symétriques dont l'amplitude de l'indicateur d'état de charge est supérieure à ladite valeur prédéterminée, de l'ensemble de la période de mesure, sont sélectionnés.

**8.** Procédé selon l'une des revendications précédentes, **caractérisé en ce que**, après l'étape d), l'intégrale par rapport au temps de ladite première quantité et de ladite deuxième quantité est rapportée à l'amplitude de l'indicateur d'état de charge, en divisant l'intégrale par l'amplitude de l'indicateur d'état de charge du cycle reconstitué symétrique sélectionné.

**9.** Procédé selon l'une des revendications précédentes, **caractérisé en ce que**, après l'étape d), l'intégrale par rapport au temps de ladite première quantité et de ladite deuxième quantité est rapportée à un nombre de sous-ensembles déconnectables qui constituent l'accumulateur électrique, en multipliant l'intégrale par un facteur relatif au rapport entre les sous-ensembles connectés lors de l'opération de décharge du cycle reconstitué symétrique sélectionné, et les sous-ensembles connectés lors de l'opération de charge du cycle reconstitué symétrique sélectionné.

**10.** Procédé selon l'une des revendications précédentes, **caractérisé en ce que**, à l'étape b), ladite valeur prédéterminée est égale à 10 %.

**11.** Procédé selon l'une des revendications précédentes, **caractérisé en ce que** lesdites mesures de paramètres représentatifs au moins du courant délivré par l'accumulateur électrique, et de l'indicateur d'état de charge de l'accumulateur électrique, sont réalisées par un système de gestion de batterie connecté à l'accumulateur électrique.

**12.** Procédé selon l'une des revendications précédentes, **caractérisé en ce que** ledit indicateur de l'état de charge de l'accumulateur électrique est :

- l'état de charge (SOC) quand cette donnée est disponible et fiable ;
- une tension limitante ($U_{lim}$) dans le cas contraire.

**13.** Système de gestion de batterie ou système de gestion de l'énergie d'une centrale électrique, **caractérisé en ce qu'**il est configuré pour mettre en oeuvre le procédé selon l'une des revendications 1 à 12.

**14.** Produit programme d'ordinateur comprenant des instructions qui conduisent le système de gestion de batterie ou le système de gestion de l'énergie d'une centrale électrique selon la revendication 13 à exécuter les étapes du procédé selon l'une des revendications 1 à 12.

**Patentansprüche**

**1.** Verfahren zum Bestimmen eines Effizienzindikators eines elektrischen Akkumulators, wobei dieses Verfahren die folgenden Schritte umfasst:

- Erfassen der Messungen von Parametern, die mindestens für den Strom bezüglich des elektrischen Akkumulators repräsentativ sind, und eines Ladezustandsindikators des elektrischen Akkumulators, wobei diese Erfassung über einen Messzeitraum (PM) ausgeführt wird, der eine Menge von Lade- und Entladevorgängen des elektrischen Akkumulators umfasst;

wobei dieses Verfahren **dadurch gekennzeichnet ist, dass** es die folgenden Schritte umfasst:

- a) Umwandeln der Menge von Lade- und Entladevorgängen des Messzeitraums (PM) in eine äquivalente Menge von symmetrischen rekonstruierten Zyklen, wobei jeder symmetrische rekonstruierte Zyklus einen Ladevorgang und einen Entladevorgang mit gleicher Amplitude des Ladezustandsindikators umfasst;
- b) Auswählen mindestens eines symmetrischen rekonstruierten Zyklus, bei dem die Amplitude des Ladezustandsindikators größer als ein vorbestimmter Wert ist;
- c) für eine vorbestimmte physikalische Größe, die mindestens den Strom bezüglich des elektrischen Akkumulators beinhaltet, und für mindestens einen ausgewählten symmetrischen rekonstruierten Zyklus: Bestimmen einer ersten Menge der vorbestimmten physikalischen Größe, die bei dem Ladevorgang an den elektrischen Akkumulator abgegeben wird, und Bestimmen einer zweiten Menge der vorbestimmten physikalischen Größe, die bei dem Entladevorgang von dem elektrischen Akkumulator abgegeben wird;
- d) Bestimmen des Zeitintegrals der ersten Menge und der zweiten Menge;
- e) Bestimmen eines Effizienzindikators des elektrischen Akkumulators, indem das Integral der zweiten Menge durch das Integral der ersten Menge dividiert wird.

**2.** Verfahren nach Anspruch 1, **dadurch gekennzeichnet, dass** im Schritt a) die Umwandlung in symmetrische rekonstruierte Zyklen ausgeführt wird, indem die steigenden Minima und die fallenden Maxima der Lade- und Entladevorgänge des Messzeitraums paarweise zugeordnet werden.

**3.** Verfahren nach Anspruch 2, **dadurch gekennzeichnet, dass** im Schritt a) die Umwandlung durch Anwenden der Rainflow-Zählmethode ausgeführt wird.

**4.** Verfahren nach einem der vorhergehenden Ansprüche, **dadurch gekennzeichnet, dass** die vorbestimmte physikalische Größe der Strom bezüglich des elektrischen Akkumulators ist, wobei das Zeitintegral dieser Größe eine Kapazität ist, wobei der bestimmte Effizienzindikator ein Coulomb-Effizienz-Indikator ist.

**5.** Verfahren nach einem der Ansprüche 1 bis 3, **dadurch gekennzeichnet, dass** die vorbestimmte physikalische Größe die Leistung bezüglich des elektrischen Akkumulators ist, wobei das Zeitintegral dieser Größe eine Energie ist, wobei der bestimmte Effizienzindikator ein Energieeffizienz-Indikator ist.

**6.** Verfahren nach einem der vorhergehenden Ansprüche, **dadurch gekennzeichnet, dass** beim Schritt b) eine Mehrzahl von symmetrischen rekonstruierten Zyklen ausgewählt wird und im Schritt e) die Effizienzindikatoren bezüglich aller ausgewählten symmetrischen rekonstruierten Zyklen Mittelwerte sind.

**7.** Verfahren nach Anspruch 6, **dadurch gekennzeichnet, dass** im Schritt b) alle symmetrischen rekonstruierten Zyklen, bei denen die Amplitude des Ladezustandsindikators größer als der vorbestimmte Wert ist, des gesamten Messzeitraums ausgewählt werden.

**8.** Verfahren nach einem der vorhergehenden Ansprüche, **dadurch gekennzeichnet, dass** nach dem Schritt d) das Zeitintegral der ersten Menge und der zweiten Menge in Bezug zur Amplitude des Ladezustandsindikators gesetzt wird, indem das Integral durch die Amplitude des Ladezustandsindikators des ausgewählten symmetrischen rekonstruierten Zyklus dividiert wird.

**9.** Verfahren nach einem der vorhergehenden Ansprüche, **dadurch gekennzeichnet, dass** nach dem Schritt d) das Zeitintegral der ersten Menge und der zweiten Menge in Bezug zu einer Anzahl von trennbaren Untereinheiten, die den elektrischen Akkumulator bilden, gesetzt wird, indem das Integral mit einem Faktor bezüglich des Verhältnisses zwischen den Untereinheiten, die bei dem Entladevorgang des ausgewählten symmetrischen rekonstruierten Zyklus angeschlossen sind, und den Untereinheiten, die bei dem Ladevorgang des ausgewählten symmetrischen rekonstruierten Zyklus angeschlossen sind, multipliziert wird.

**10.** Verfahren nach einem der vorhergehenden Ansprüche, **dadurch gekennzeichnet, dass** im Schritt b) der vorbestimmte Wert gleich 10 % ist.

**11.** Verfahren nach einem der vorhergehenden Ansprüche, **dadurch gekennzeichnet, dass** die Messungen von Parametern, die mindestens für den von dem elektrischen Akkumulator ausgegebenen Strom repräsentativ sind, und des Ladezustandsindikators des elektrischen Akkumulators von einem Batteriemanagementsystem ausgeführt werden, das an den elektrischen Akkumulator angeschlossen ist.

**12.** Verfahren nach einem der vorhergehenden Ansprüche, **dadurch gekennzeichnet, dass** der Ladezustandsindikator des elektrischen Akkumulators:

   - der Ladezustand (SOC) ist, wenn dieses Datenelement verfügbar und zuverlässig ist;
   - anderenfalls eine begrenzende Spannung ($U_{lim}$) ist.

**13.** Batteriemanagementsystem oder Energiemanagementsystem eines Kraftwerks, **dadurch gekennzeichnet, dass** es dazu ausgestaltet ist, das Verfahren nach einem der Ansprüche 1 bis 12 durchzuführen.

**14.** Computerprogrammprodukt mit Anweisungen, die das Batteriemanagementsystem oder das Energiemanagementsystem eines Kraftwerks nach Anspruch 13 veranlassen, die Schritte des Verfahrens nach einem der Ansprüche 1 bis 12 auszuführen.

**Claims**

**1.** Method for determining a round-trip-efficiency indicator for an electric accumulator, this method comprising the following steps:

   - acquiring measurements of parameters representative at least of the current associated with the electric accumulator, and of a state-of-charge indicator of the electric accumulator, this acquisition being carried out over a measurement period (PM) comprising a set of operations of charging and discharging the electric accumulator;

   this method being **characterized in that** it comprises the following steps:

   - a) converting the set of charging and discharging operations of the measurement period (PM) into an equivalent set of symmetrical reconstructed cycles, each symmetrical reconstructed cycle comprising one charging operation and one discharging operation of same amplitude of the state-of-charge indicator;

- b) selecting at least one symmetrical reconstructed cycle the amplitude of the state-of-charge indicator of which is greater than a predetermined value;

- c) for a predetermined physical quantity involving at least the current associated with the electric accumulator, and for at least one selected symmetrical reconstructed cycle: determining a first magnitude of said predetermined physical quantity delivered to the electric accumulator during the charging operation, and determining a second magnitude of said predetermined physical quantity delivered by the electric accumulator during the discharging operation;

- (d) determining the integral with respect to time of said first magnitude and of said second magnitude;

- (e) determining a round-trip-efficiency indicator for the electric accumulator by dividing the integral of the second magnitude by the integral of the first magnitude.

2. Method according to Claim 1, **characterized in that**, in step a), the conversion into symmetrical reconstructed cycles is carried out by associating in pairs increasing minima and decreasing maxima of the charging and discharging operations of the measurement period.

3. Method according to Claim 2, **characterized in that**, in step a), the conversion is carried out by applying the rainflow-counting method.

4. Method according to one of the preceding claims, **characterized in that** said predetermined physical quantity is the current associated with the electric accumulator, the integral of this quantity with respect to time being a capacity, the determined round-trip-efficiency indicator being a faradic-efficiency indicator.

5. Method according to one of Claims 1 to 3, **characterized in that** said predetermined physical quantity is the power associated with the electric accumulator, the integral of this quantity with respect to time being an energy, the determined round-trip-efficiency indicator being an energy-efficiency indicator.

6. Method according to one of the preceding claims, **characterized in that**, in step b), a plurality of symmetrical reconstructed cycles are selected, and, in step e) the round-trip-efficiency indicators associated with all the selected symmetrical reconstructed cycles are averaged.

7. Method according to Claim 6, **characterized in that**, in step b), all the symmetrical reconstructed cycles the amplitude of the state-of-charge indicator of which is greater than said predetermined value, of all the measurement period, are selected.

8. Method according to one of the preceding claims, **characterized in that**, after step d), the integral with respect to time of said first magnitude and of said second magnitude is related to the amplitude of the state-of-charge indicator, by dividing the integral by the amplitude of the state-of-charge indicator of the selected symmetrical reconstructed cycle.

9. Method according to one of the preceding claims, **characterized in that**, after step d), the integral with respect to time of said first magnitude and of said second magnitude is related to a number of constituent disconnectable subsets of the electric accumulator, by multiplying the integral by a factor relative to the ratio between the subsets connected during the discharging operation of the selected symmetrical reconstructed cycle, and the subsets connected during the charging operation of the selected symmetrical reconstructed cycle.

10. Method according to one of the preceding claims, **characterized in that**, in step b), said predetermined value is equal to 10%.

11. Method according to one of the preceding claims, **characterized in that** said measurements of parameters representative at least of the current delivered by the electric accumulator, and of the state-of-charge indicator of the electric accumulator, are carried out by a battery management system connected to the electric accumulator.

12. Method according to one of the preceding claims, **characterized in that** said state-of-charge indicator of the electric accumulator is:

- the state of charge (SOC) when this datum is available and reliable;
- a limiting voltage ($U_{lim}$) in the contrary case.

13. Battery management system or power management system of a power plant, **characterized in that** it is configured to implement the method according to one of Claims 1 to 12.

14. Computer program product comprising instructions that cause the battery management system or power management system of a power plant according to Claim 13 to execute the steps of the method according to one of Claims 1 to 12.

Fig. 1

Fig. 2

Fig. 3

Fig. 4

Fig. 5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **BOBANAC et al.** Determining Lithium-ion Battery One-way Energy Efficiencies: Influence of C-rate and Coulombic Losses. *IEEE EUROCON 2021, 19th International Conférence on Smart Technologies,* 385-389